(19) Europäisches Patentamt
European Patent Office
Office européen des brevets

(11) **EP 2 689 221 B1**

(12) **FASCICULE DE BREVET EUROPEEN**

(45) Date de publication et mention de la délivrance du brevet:
**01.06.2016 Bulletin 2016/22**

(21) Numéro de dépôt: **12712292.7**

(22) Date de dépôt: **15.03.2012**

(51) Int Cl.:
***G01K 7/02*** (2006.01)

(86) Numéro de dépôt international:
**PCT/FR2012/000094**

(87) Numéro de publication internationale:
**WO 2012/131183 (04.10.2012 Gazette 2012/40)**

(54) **CAPTEUR DIFFERENTIEL DE TEMPERATURE ET SES CAPACITES EN TECHNOLOGIE CMOS/BICMOS**

DIFFERENZIALTEMPERATURSENSOR UND SEINE CMOS/BICMOS-TECHNOLOGIEKOMPETENZEN

DIFFERENTIAL TEMPERATURE SENSOR AND ITS CMOS/BICMOS TECHNOLOGY CAPABILITIES

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **25.03.2011 FR 1100894**

(43) Date de publication de la demande:
**29.01.2014 Bulletin 2014/05**

(73) Titulaires:
• **Commissariat à l'Énergie Atomique et aux Énergies Alternatives**
**75015 Paris (FR)**
• **ST-Ericsson SA**
**1228 Plan-les-Ouates (CH)**

(72) Inventeurs:
• **SAVELLI, Guillaume**
**F-38000 Grenoble (FR)**
• **COTTIN, Denis**
**F-38920 Crolles (FR)**

(74) Mandataire: **Talbot, Alexandre**
**Cabinet Hecké**
**Europole**
**10, rue d'Arménie - BP 1537**
**38025 Grenoble Cedex 1 (FR)**

(56) Documents cités:
**WO-A1-2011/012586    FR-A5- 2 113 383**

• **NAJAFI K ED - MASSOOD TABIB-AZAR ET AL: "SILICON INTEGRATED MICROSENSORS", INTEGRATED OPTICS AND MICROSTRUCTURES. BOSTON, SEPT. 8 - 9, 1992; [PROCEEDINGS OF THE CONFERENCE ON INTEGRATED OPTICS AND MICROSTRUCTURES], BELLINGHAM, SPIE, US, vol. CONF. 1, 8 septembre 1992 (1992-09-08), pages 235-246, XP000700816, ISBN: 978-0-8194-0972-0**

## Description

**Domaine technique de l'invention**

L'invention concerne le domaine des capteurs de température, et plus précisément des capteurs différentiels à effet Seebeck.

L'invention concerne également un procédé de co-intégration d'un capteur différentiel à effet Seebeck et un transistor à effet de champ.

**État de la technique**

Avec l'augmentation de la densité d'intégration, la puissance dissipée au sein des dispositifs microélectroniques ne cesse de croître. L'augmentation de la puissance dissipée peut générer un phénomène dit d'auto-échauffement, qui est responsable de la dégradation de certaines caractéristiques physiques et électriques des dispositifs microélectroniques. À titre d'exemple, la mobilité des porteurs qui dépend fortement de la température peut décroître dans ces conditions. Une dégradation de la mobilité des porteurs s'avère néfaste pour la vitesse de commutation des dispositifs microélectroniques en particulier, et pour la rapidité d'exécution des fonctions du circuit intégré en général.

Actuellement, certains circuits intégrés réalisés selon la technologie CMOS comportent un système de commande et de gestion de la puissance dynamique. Un tel système est relié à plusieurs capteurs thermiques placés à différents points critiques du circuit intégré. Lorsque la température dépasse un certain seuil, le système de gestion de la puissance dynamique peut, par exemple, déclencher un ventilateur ou suspendre l'activité de certains dispositifs. L'efficacité de ce type de système dépend des informations sur l'état d'échauffement du circuit intégré.

Dès lors, un besoin de mise en oeuvre de sondes de températures précises et compatibles avec les technologies CMOS ou BiCMOS est apparu. Ces capteurs thermiques peuvent être réalisés par des jonctions p-n intégrées simultanément avec les dispositifs actifs du circuit électronique. La température détectée par ce capteur actif est obtenue en mesurant la tension aux bornes de la diode formée dans le substrat. Ce type de capteur de température est peu précis et consomme un courant permanent certes faible mais très sensible aux perturbations causées par couplage capacitif avec les interconnexions denses au sein des circuits intégrés. D'autre part, ces capteurs, réalisés dans le silicium comme les circuits associés, sont aussi sensibles aux courants parasites créés par le fonctionnement du circuit. Dans ce contexte, ce type de capteur thermique peut être considéré comme peu adapté pour les circuits intégrés denses avec des fréquences d'utilisation élevées.

Un autre type de capteur thermique, passif et précis existe. Ce sont des capteurs différentiels qui exploitent l'effet Seebeck et qui ne consomment pas de courant. Ils comportent un ou plusieurs thermocouples disposés dans un gradient de température entre une source froide et une source chaude.

Un exemple de ce type de capteur différentiel intégré en technologie CMOS est décrit dans l'article intitulé « Differential temperature sensors in 0.35μm CMOS technology » écrit par E. Aldrete-Vidrio et al. et publié à la conférence THERMINIC 2005, Belgirate, Lago Maggiore, Italy.

Un autre exemple est décrit dans la demande de brevet WO2001/012586 A1 Ces capteurs ont été réalisés sur un substrat en silicium. Ils comportent plusieurs barreaux parallèles connectés électriquement en série. Une extrémité de ces barreaux est disposée au niveau d'une source froide et l'autre extrémité est disposée au niveau d'une source chaude. Dans cette étude, les barreaux ont été formés à base de silicium polycristallin. La longueur des barreaux est de l'ordre de 500 μm, et leur épaisseur est de l'ordre de 0,65 μm. Ainsi, il a été possible de former plusieurs thermocouples connectés électriquement en série et thermiquement en parallèle.

Généralement, la sensibilité d'un thermocouple à base de barreaux en silicium polycristallin est de l'ordre de quelques centaines de μV/°C. Ainsi, les tensions aux bornes de sortie de tels capteurs sont en général de l'ordre de quelques mV/°C. Cette tension peut être considérée comme faible par rapport aux tensions appliquées aux bornes des dispositifs actifs usuels des circuits intégrés. En effet, ces tensions peuvent atteindre des valeurs de l'ordre de 1 à 10 V voire plus.

Par ailleurs, pour suivre au mieux la température des points chauds ces capteurs différentiels sont placés au voisinage du circuit intégré et non à proximité du circuit de gestion de la puissance dynamique. Par conséquent, les distances entre les capteurs de température et le circuit de gestion peuvent atteindre quelques dizaines à quelques centaines de micromètres et même atteindre le millimètre à l'intérieur du circuit intégré.

Dans ces conditions, les connexions électriques reliant les capteurs de température et le circuit de gestion peuvent être disposées au voisinage de nombreuses interconnexions. Ces lignes d'interconnexion peuvent véhiculer des signaux électriques ayant des amplitudes largement supérieures à l'amplitude de la tension aux bornes de sortie du capteur différentiel. Il en résulte que des perturbations électriques causées par des couplages capacitifs peuvent altérer l'acheminement du signal électrique du capteur vers le circuit de gestion. De ce fait, la gestion de la puissance dynamique du circuit intégré peut être faite sur la base de valeurs biaisées de la température malgré la précision des capteurs différentiels.

De ce fait, une attention particulière doit être accordée aux opérations de récupération du signal aux bornes de sortie du capteur et de sa transmission vers le système de gestion de la puissance. Des dispositifs actifs et/ou passifs peuvent être connectés en aval du capteur afin d'améliorer l'efficacité de ces opérations.

L'intégration du circuit microélectronique devient alors plus complexe et plus coûteuse.

**Objet de l'invention**

Dans certaines applications, on aurait besoin d'un dispositif thermoélectrique qui permet, en outre, de détecter efficacement une différence de température et de la communiquer à un autre dispositif tout en évitant des inconvénients liés aux perturbations électriques. On tend à satisfaire ce besoin en prévoyant un dispositif thermoélectrique comportant un substrat en matériau semi-conducteur ; une couche électriquement isolante recouvrant une face du substrat ; un thermocouple séparé du substrat par la couche électriquement isolante ; des première et seconde bornes de sortie reliées au thermocouple. La couche électriquement isolante est formée de manière à comporter une première portion présentant une première valeur de capacité par unité de surface et une deuxième portion présentant une deuxième valeur de capacité par unité de surface inférieure à la première valeur ; la première borne de sortie comporte un premier condensateur ayant une première électrode formée par un premier barreau en matériau électriquement conducteur et une deuxième électrode formée par une partie du substrat faisant face audit premier barreau et séparée de la première électrode par la première portion de la couche électriquement isolante. Le premier barreau est disposé de manière à chevaucher la deuxième portion de la couche électriquement isolante pour relier le thermocouple.

Selon un mode de réalisation, la seconde borne de sortie comporte un deuxième condensateur ayant une première électrode formée par un deuxième barreau en matériau électriquement conducteur et une deuxième électrode formée par une partie du substrat faisant face audit deuxième barreau et séparée de la première électrode par la première portion de la couche électriquement isolante. Le deuxième barreau est disposé de manière à chevaucher la deuxième portion de la couche électriquement isolante pour relier le thermocouple.

Selon un autre mode de réalisation, une zone du substrat faisant face à la première portion de la couche électriquement isolante est dopée de manière à former une jonction P/N avec une zone adjacente du substrat.

Selon un autre mode de réalisation, le premier barreau et la deuxième électrode du condensateur de la première borne de sortie sont respectivement connectés électriquement à une première ligne métallique et à une deuxième ligne métallique de manière à ce que lesdites première et deuxième lignes métalliques soient séparées l'une de l'autre par une couche en matériau électriquement isolant et à ce qu'elles soient disposées dans un plan parallèle et différent du plan du premier barreau.

Selon un mode de réalisation, les premier et deuxième barreaux sont en matériaux semi-conducteurs dopés et participent à la formation d'au moins un thermocouple.

Selon un autre mode de réalisation, le premier barreau reliant une jonction thermoélectrique à la première sortie a un premier type de conductivité et le deuxième barreau a une première portion en premier type de conductivité et une seconde portion en second type de conductivité de manière à ce que la première portion du deuxième barreau et le premier barreau aient le même type de conductivité au-dessus de la première portion de la couche électriquement isolante, lesdites première et seconde portions *(du deuxième barreau)* étant alignées.

Selon un mode de réalisation, le dispositif thermoélectrique comporte une couche à base d'un matériau métallique forme un court-circuit entre les première et seconde portions du deuxième barreau.

Selon un autre mode de réalisation, la première portion de la couche électriquement isolante présente une première valeur de résistance thermique et la deuxième portion de la couche électriquement isolante présente une deuxième valeur de résistance thermique supérieure à la première valeur.

Selon un autre mode de réalisation, le dispositif thermoélectrique comporte une pluralité de thermocouples connectés en série, chaque thermocouple comportant deux barreaux reliés par une liaison thermoélectrique, le premier barreau étant le barreau le plus long des barreaux du dispositif (thermoélectrique).

Selon un mode de réalisation, l'épaisseur de la première portion de la couche électriquement isolante est comprise entre 3 et 200 Å.

On prévoit également la mise en oeuvre d'un procédé de fabrication d'un dispositif thermoélectrique utilisant un substrat en un matériau semi-conducteur ayant un premier type de conductivité et comportant une couche électriquement isolante recouvrant une face du substrat ; ladite couche électriquement isolante comporte des première et troisième portions présentant des premières valeurs de capacité par unité de surface et de conductance thermique ; et une deuxième portion présentant des deuxièmes valeurs de capacité par unité de surface et de conductance thermique inférieures respectivement aux premières valeurs. Le procédé comporte une étape de formation simultanée de premier et deuxième barreaux en matériau électriquement conducteur s'étendant au-dessus des première et deuxième portions de la couche électriquement isolante ; et un troisième barreau en matériau électriquement conducteur au-dessus de la troisième portion de la couche électriquement isolante. Le procédé comporte également une étape de dopage des premier, deuxième et troisième barreaux permettant la formation d'un thermocouple au moyen des premier et deuxième barreaux et d'un transistor MOS au moyen du troisième barreau.

Selon un mode de mise en oeuvre, avant la formation des premier, deuxième et troisième barreaux, des première et deuxième zones sont formés dans le substrat ; les première et deuxième zones ayant le second type de conductivité et faisant face respectivement aux première et troisième portions de la couche électriquement isolante.

## Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :

- la figure 1 illustre, schématiquement, une vue de dessus d'un mode de réalisation d'un dispositif thermoélectrique ;
- la figure 2 illustre une vue en coupe selon l'axe $xox_1$' de la figure 1 ;
- la figure 3 illustre une vue en coupe selon l'axe $xox_2$' de la figure 1 ;
- la figure 4 illustre schématiquement une vue de dessus d'une variante de réalisation d'un dispositif thermoélectrique ;
- la figure 5 illustre une vue en coupe selon l'axe $yoy$' de la figure 4 ;
- les figures 6 à 8 illustrent des étapes successives d'un mode de mise en oeuvre d'un dispositif thermoélectrique et d'un transistor à effet de champ.

## Description d'un mode préférentiel de l'invention

Afin de bénéficier des avantages d'un système de gestion de la puissance dissipée dans un circuit intégré, il est préférable que ce système soit associé à des capteurs thermiques passifs, précis et faciles à réaliser.

Il est donc avantageux de tirer profit des capteurs différentiels à effet Seebeck réalisés dans la technologie du circuit intégré tout en évitant les perturbations électriques qui peuvent apparaître aux bornes de sortie de ces capteurs.

Afin de s'affranchir de ces inconvénients, on envisage de réaliser un capteur thermique différentiel, isolé électriquement du substrat et muni d'un condensateur mis en parallèle avec au moins une des deux bornes de sortie du capteur, de préférence avec chacune des deux bornes de sortie du capteur.

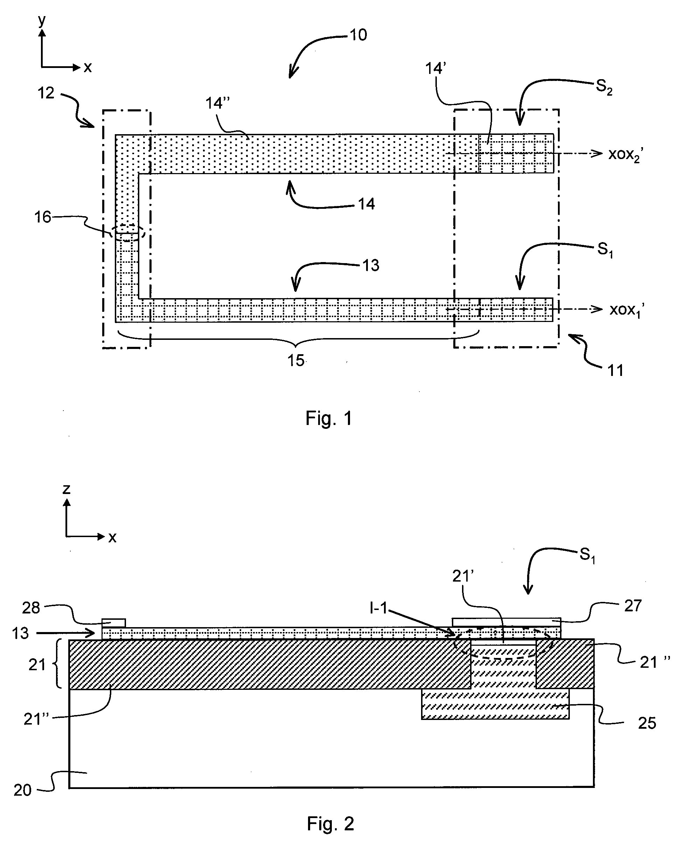

La figure 1 illustre schématiquement une vue de dessus d'un mode de réalisation d'un dispositif thermoélectrique 10 qui tend à satisfaire ces contraintes. En fonctionnement, le dispositif 10 est disposé dans un gradient de température défini entre une source chaude et une source froide. Une extrémité du dispositif 10 est alors située au niveau d'un premier côté 12 agencé à proximité d'une première source, par exemple une source de chaleur et l'autre extrémité est située au niveau d'un second côté 11 agencé de manière à être thermiquement connecté avec une deuxième source qui est une source de référence ou une source froide. Pour des raisons de clarté, on utilisera les termes « côté chaud » et « côté froid » pour désigner respectivement le premier côté 12 et le second côté 11. À titre d'exemple, une source chaude peut être formée par un ou plusieurs composants actifs et/ou passifs qui, en dissipant une certaine puissance électrique peuvent engendrer une élévation de la température. Dans une variante de réalisation, la position des sources chaude et froide peut être inversée.

Le dispositif thermoélectrique 10 comporte au moins un thermocouple 15. Ce thermocouple génère, en fonction du gradient de température subi, une différence de potentiel entre des première $S_1$ et deuxième $S_2$ bornes de sortie. On entend par gradient de température, la différence de température entre les côtés chaud 12 et froid 11.

Comme illustré à la figure 1, le thermocouple 15 est, de préférence, en forme de U et il comporte des premier 13 et deuxième 14 barreaux qui sont sensiblement parallèles. Les barreaux 13 et 14 sont formés en matériaux électriquement conducteurs et ils sont reliés électriquement entre eux à l'une de leur extrémité, de manière à former une jonction thermoélectrique 16, ici au niveau du côté chaud 12. La jonction est disposée sur le premier côté alors que les sorties sont disposées sur le second côté 11.

Les barreaux du thermocouple 15 sont formés à base de matériaux de natures thermoélectriques différentes c'est-à-dire des matériaux aptes à générer l'effet Seebeck. Par exemple, les matériaux semi-conducteurs de type monocristallin ou polycristallin ont des caractéristiques thermoélectriques intéressantes. De préférence, les premier 13 et deuxième 14 barreaux sont en matériaux semi-conducteurs dopés. Ici, les parties des barreaux 13 et 14 qui participent à la formation du thermocouple 15 sont formées à base de silicium polycristallin dopé N et P, pour réaliser deux matériaux thermoélectriques différents aptes à former un thermocouple.

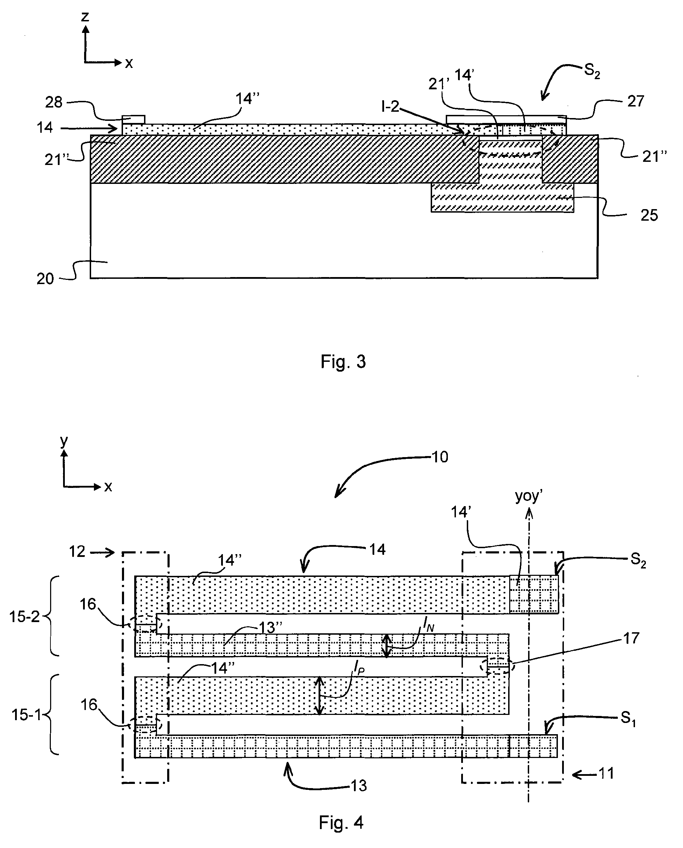

Les bornes de sortie $S_1$ et $S_2$ sont reliées au thermocouple 15 et au moins une des sorties comporte un condensateur. Dans un mode particulier de réalisation, la première borne de sortie $S_1$ et la deuxième borne de sortie $S_2$ comportent respectivement des premier I-1 et deuxième I-2 condensateurs. Ces condensateurs sont représentés aux figures 2 et 3.

Les figures 2 et 3 illustrent des vues en coupe selon les axes $xox_1$' et $xox_2$' de la figure 1. Comme illustré sur ces vues en coupe, le dispositif thermoélectrique 10 comporte un substrat 20 en matériau semi-conducteur. Ce substrat peut être de type massif en silicium, en germanium, ou tout autre matériau semi-conducteur. Le substrat 20 peut également être de type semi-conducteur sur isolant. Le dispositif 10 comporte également une couche 21 électriquement isolante qui recouvre partiellement une face du substrat 20. La couche 21 sépare le thermocouple 15 du substrat 20, ce qui permet d'isoler électriquement le thermocouple 15 du substrat 20. Cette couche 21 comporte des première 21' et deuxième 21" portions. La première portion 21' de la couche électriquement isolante 21 présente une première valeur $C_1$ de capacité par unité de surface et la deuxième portion 21" présente une deuxième valeur $C_2$ de capacité par unité de surface inférieure à la première valeur.

Lorsque deux couches électriquement conductrices sont séparées par une couche électriquement isolante d'une épaisseur e, cette dernière présente une capacité par unité de surface qui peut être définie selon l'équation :

$$C = \frac{\varepsilon_r \cdot \varepsilon_o}{e} \qquad (1)$$

où $\varepsilon_r$ représente la permittivité diélectrique relative et $\varepsilon_o$ la permittivité diélectrique du vide.

De ce fait, les valeurs de capacité par unité de surface $C_1$ et $C_2$ dépendent principalement de la nature des matériaux utilisés dans les portions 21' et 21" et de leurs épaisseurs. Dans une variante de réalisation, les matériaux des portions 21' et 21" sont différents et de préférence le matériau de la portion 21" a une permittivité diélectrique inférieure à celle du matériau de la portion 21' dans un rapport de 1 à 5. Les épaisseurs peuvent être dans des rapports beaucoup plus importants de 10 à 1000 ce qui permet d'obtenir des capacités très différentes. Par exemple, la portion 21' peut être réalisée dans un oxyde de grille standard (quelques dizaines d'Angström) des technologies CMOS et la portion 21" peut être réalisée dans un oxyde épais de ces mêmes technologies (quelques centaines de nanomètres).

Comme illustré à la figure 2, le premier barreau 13 du thermocouple 15 s'étend sur la portion 21' et sur la portion 21". La première borne de sortie $S_1$ est disposée sur la portion 21' et est formée par le premier barreau 13. la première borne de sortie $S_1$ comporte également le premier condensateur I-1 qui présente une valeur de capacité par unité de surface égale à $C_1$. En effet, le condensateur I-1 comporte une première électrode formée par le premier barreau 13 et une deuxième électrode formée par une partie 25 du substrat 20. Cette partie du substrat est séparée de la première électrode par la première portion 21' de la couche électriquement isolante et elle est disposée de manière à faire face au premier barreau 13. Le premier barreau 13 forme la sortie $S_1$ dans la portion 21' et chevauche la deuxième portion 21" de la couche électriquement isolante pour relier le thermocouple 15 avec la sortie $S_1$. Dans cette configuration, le barreau 13 forme une partie du thermocouple 15, une partie du condensateur I-1 et la borne de sortie $S_1$.

De manière analogue dans un mode de réalisation préférentiel, et comme illustré à la figure 3, le deuxième barreau 14 du thermocouple 15 s'étend sur la portion 21' et sur la portion 21". La deuxième borne de sortie $S_2$ comporte un deuxième condensateur I-2. Une première électrode de ce condensateur est formée par le deuxième barreau 14 en matériau électriquement conducteur. Le condensateur I-2 comporte également une deuxième électrode formée par une partie 25 du substrat 20. Cette partie du substrat est séparée de la première électrode par la première portion 21' de la couche électriquement isolante et elle est disposée de manière à faire face au deuxième barreau 14. Le condensateur I-2 présente alors une valeur de capacité électrique par unité de surface égale à $C_1$. Le deuxième barreau 14 forme la borne de sortie $S_2$ dans la portion 21' et chevauche la deuxième portion 21" de la couche électriquement isolante pour relier le thermocouple 15 avec la sortie $S_2$. Dans cette configuration, le barreau 14 forme une partie du thermocouple 15, une partie du condensateur I-2 et la borne de sortie $S_2$.

Cette architecture particulière permet d'intégrer un ou deux condensateurs sur la sortie du dispositif thermoélectrique 10, à proximité immédiate et entre les sorties $S_1$ et $S_2$ et sans engendrer un encombrement du substrat. De plus, cette zone ne serait de toute façon pas utilisée pour intégrer des composants. En fonctionnement, les condensateurs joueront le rôle de capacités de découplage et limiteront les perturbations électriques causées par les signaux électriques dans les interconnexions passant au voisinage du dispositif 10. Généralement, une capacité de l'ordre de 10 fF à 1 pF est associée à chacune des bornes de sortie d'un dispositif tel que le dispositif thermoélectrique 10. De préférence, la capacité électrique des condensateurs I-1 et I-2 est comprise entre 100 fF à 10 pF.

À titre d'exemple, avec une épaisseur de 3 nm d'une première portion 21' en oxyde de silicium, les condensateurs I-1 et I-2 auront une valeur de capacité électrique par unité de surface de l'ordre de $11{,}5 \ 10^{-3}$ F/m$^2$. Par conséquent, avec une portion des premier 13 et deuxième 14 barreaux ayant une surface de 40 $\mu$m$^2$ et formant la première électrode des condensateurs I-1 et I-2, la capacité électrique des condensateurs I-1 et I-2 serait de l'ordre de 500 fF.

Selon un mode particulier de réalisation qui peut être combiné aux précédents, le substrat est d'un premier type de conductivité et il comporte une zone 25 dopée d'un second type de conductivité qui forme une jonction P/N avec une zone adjacente du substrat 20 ce qui permet d'assurer une isolation électrique. Ainsi, les perturbations parasites présent dans le substrat 20 ne sont pas propagées vers les sorties $S_1$ et $S_2$ du thermocouple 10. Comme illustré aux figures 2 et 3, cette zone 25 est disposée de manière à faire face à la première portion 21' de la couche électriquement isolante 21 et former la deuxième électrode du condensateur I-1, ou des condensateurs I-1 et I-2. Un tel dopage permet de diminuer la résistivité électrique de cette partie du substrat et, de ce fait, de la deuxième électrode des condensateurs I-1 et I-2.

Dans un mode de réalisation préférentiel, la zone 25 est du même type de conductivité que la portion du barreau qui la recouvre.

Selon un autre mode de réalisation, qui peut être combiné aux modes précédents, le premier barreau 13 qui relie la sortie $S_1$ à la jonction thermoélectrique 16 est dans un seul type de conductivité et le deuxième barreau 14 comporte des première 14' et seconde 14" portions. Le deuxième barreau 14 relie la sortie $S_2$ à une jonction thermoélectrique, par exemple la jonction avec le barreau 13. La première portion 14' du deuxième barreau 14 a le même type de conductivité que le premier barreau 13 et est disposée au-dessus de la première portion 21' de la couche électriquement isolante. La deuxième portion 14" est du type de conductivité opposé à la première portion 14' et au premier barreau 13. Les portions 14' et 14" sont alignées pour former un barreau et la deuxième portion 14" forme la jonction 16 avec le barreau 13. Comme illustré à la figure 3, la première portion 14' participe à la formation de la première électrode du deuxième condensateur I-2 (ou du premier condensateur I-1). Selon ce mode de réalisation, les condensateurs I-1 et I-2 comportent des premières électrodes formées à partir des mêmes matériaux et ayant les mêmes types de conductivité, ce qui permet de rapprocher le comportement électrique des condensateurs I-1 et I-2. Dans le cas particulier où les deuxièmes électrodes sont également formées dans les mêmes matériaux, les condensateurs ont sensiblement des réponses électriques identiques.

Dans le mode de réalisation précédent, les première 14' et seconde 14" portions du deuxième barreau 14 ont des types de conductivité opposés, et sont électriquement reliées. Les deux portions 14' et 14" forment une jonction électrique P/N au niveau du côté froid 11. Cette jonction électrique peut engendrer la formation d'un thermocouple parasite comportant les portions 14' et 14". Ce thermocouple parasite peut perturber le fonctionnement normal du thermocouple 15 et du dispositif thermoélectrique 10.

Dans un mode de réalisation particulier illustré à la figure 3, une couche 27 en un matériau électriquement conducteur, par exemple à base d'un matériau métallique ou d'un siliciure, forme un court-circuit entre les première 14' et seconde 14" portions du deuxième barreau 14. En effet, la couche 27 recouvre la portion 14' et la jonction entre la portion 14' et la portion 14".

Dans un mode de réalisation particulier qui peut être combiné au mode précédent, pour des raisons d'équivalence électrique et thermique entre les deux bornes de sortie $S_1$ et $S_2$, cette même couche 27 est également formée au-dessus du barreau 13. Afin d'équilibrer thermiquement les parties des premier 13 et deuxième 14 barreaux qui participent à la formation du thermocouple 15, une couche 28 à base d'un matériau électriquement conducteur peut également être disposée au-dessus des extrémités de ces barreaux situées au niveau du côté chaud 12. La couche 28 assure le contact électrique entre les barreaux 13 et 14.

De préférence, les couches 27 et 28 sont formées à base du même matériau électriquement conducteur tel qu'un siliciure, un métal etc. Grâce à des conductivités thermiques plus importantes que celles des matériaux formant les barreaux 13 et 14, les couches à base d'un matériau métallique permettent généralement une diffusion efficace de la chaleur. Ainsi, une meilleure harmonisation de la température des barreaux 13 et 14 peut être obtenue au niveau du côté froid 11 et du côté chaud 12.

Comme une partie de la structure du thermocouple 15 est formée au-dessus de la zone 21' et une autre partie est formée au-dessus de la zone 21", il est avantageux d'associer des performances thermiques différentes à ces deux zones.

Dans un mode de réalisation préférentiel qui peut être combiné aux précédents modes, la première portion 21' présente une première valeur de résistance thermique Rth1 et la deuxième portion 21" présente une deuxième valeur de résistance thermique Rth2 supérieure à la première valeur. L'influence thermique du substrat au niveau de la zone 21' et des bornes de sortie $S_1$ et $S_2$ est plus importante qu'au niveau de la jonction 16 qui est disposée sur la portion 21". Ainsi l'influence du substrat est limitée à une extrémité du dispositif 10, ici le côté froid 11 et la température de jonction peut par exemple être prise comme température de référence. De préférence, les portions 21' et 21" sont à base d'un même matériau électriquement isolant et ont respectivement des première $e'$ et seconde $e''$ épaisseurs. Les épaisseurs sont choisies, dans ce cas, de manière à ce que la première épaisseur e'soit inférieure à la seconde $e''$.

Dans le cas où le substrat sous la portion 21' forme la source froide, cette caractéristique de la portion 21" permet de freiner la diffusion de la chaleur du côté chaud des barreaux 13 et 14 vers le substrat 20. Cela permet de conserver un gradient thermique maximal entre la jonction 16 et les bornes de sortie $S_1$ et $S_2$.

Dans le cas où des moyens de refroidissements actifs ou passifs sont appliqués sur la face arrière du substrat (la face opposée au dispositif 10) la température du substrat est la température minimum présente dans le dispositif 10. La face arrière représente la source froide du gradient. Comme la conductivité thermique dans le substrat est nettement supérieure à la conductivité thermique des zones 21' et 21", la source froide du gradient est formée par la zone 25. En choisissant cette température référence, la différence entre les températures des côtés froid 11 et chaud 12 peut être augmentée, ce qui permet d'améliorer la sensibilité du thermocouple.

Ainsi, chacun des barreaux participant à la formation du thermocouple 15 dispose avantageusement d'une extrémité qui est à la fois électriquement isolée et thermiquement connectée au substrat 20. Ici, cette extrémité est placée au niveau du côté froid 11. Le reste des barreaux est de préférence électriquement et thermiquement isolé du substrat 20 en matériau semi-conducteur afin d'avoir un gradient de température maximal.

En effet et comme illustré aux figures 2 et 3, les parties des barreaux 13 et 14 qui forment le thermocouple 15 sont disposées au-dessus de la deuxième portion 21" de la couche électriquement isolante. Chacune de ces parties comporte une extrémité qui est disposée au-dessus de la première portion 21' de la couche électriquement isolante. Avantageusement, la portion 21' présente une première valeur Rth1 de résistance thermique et la portion 21 " présente une deuxième valeur Rth2 de résistance thermique supérieure à la première valeur.

Dans un mode particulier de réalisation, les portions 21' et 21" sont formées à base d'un même matériau électriquement isolant, par exemple l'oxyde de silicium. Elles ont respectivement des épaisseurs $e'$ et $e''$ choisies de manière à ce que $e'$ soit inférieur à $e''$. Selon cette configuration, les conditions sur les résistances thermiques Rth1 et Rth2 et sur les capacités par unité de surface $C_1$ et $C_2$ sont vérifiées simultanément. De préférence, $e'$ est de l'ordre de quelques Angstrôm. Ainsi, la température du barreau au niveau du côté froid 11 est avantageusement proche de celle du substrat 20. L'épaisseur de la portion 21' peut être comprise, par exemple, entre 3 et 200 Å et l'épaisseur de la portion 21" peut être comprise entre 100 et 1000 nm.

Dans une variante de réalisation, les matériaux des portions 21' et 21" sont différents et de préférence le matériau de la couche 21' a une conductivité thermique supérieure à celle du matériau de la couche 21".

La figure 4 illustre schématiquement une vue de dessus d'un autre mode de réalisation du dispositif thermoélectrique 10. Comme illustré à cette figure, le dispositif thermoélectrique 10 comporte des éléments semblables à ceux illustrés à la figure 1, désignés par des mêmes références. On retrouve notamment les bornes de sortie $S_1$ et $S_2$, les côtés froid 11 et chaud 12, les premier 13 et deuxième 14 barreaux, et la jonction 16 formée par les barreaux participant à la formation d'un thermocouple. Les mêmes variantes de réalisation décrites précédemment peuvent être intégrées.

Selon ce mode de réalisation, le dispositif thermoélectrique 10 comporte deux thermocouples 15-1 et 15-2 semblables au thermocouple 15 de la figure 1. Les thermocouples 15-1 et 15-2 sont reliés électriquement via une jonction 17. Les thermocouples 15-1 et 15-2 sont électriquement en série et thermiquement en parallèle dans le gradient de température. Chacun des thermocouples 15-1 et 15-2 est disposé de manière à avoir une extrémité au niveau du côté chaud 12 et l'autre extrémité au niveau du côté froid 11. Le premier barreau 13 participe à la formation du thermocouple 15-1 et la première borne de sortie $S_1$ et le deuxième barreau 14 participe à la formation du thermocouple 15-2 et la deuxième borne de sortie $S_2$. Afin de compléter les thermocouples 15-1 et 15-2, des barreaux additionnels 13" et 14" sont formés. Les différents barreaux sont parallèles entre eux avec une partie coudée pour avoir une connexion.

Afin d'augmenter la sensibilité du dispositif thermoélectrique, ce dernier peut comporter plus de deux thermocouples montés électriquement en série. De préférence, le dispositif 10 comporte entre 1 et 100 thermocouples et même plus si nécessaire. Dans un mode de réalisation qui peut être combiné aux précédents le dispositif thermoélectrique comporte m thermocouples ; m étant un nombre entier supérieure ou égale à 1. Les m thermocouples sont formés par des barreaux en matériau électriquement conducteur. Ces barreaux sont disposés en « créneau » et peuvent être formés par exemple, en un matériau semi-conducteur de manière à ce que deux barreaux adjacents et reliés entre eux aient deux types de conductivités différents. La disposition des barreaux en « créneau » permet avantageusement de minimiser la surface du substrat utilisée pour la réalisation du dispositif 10. Dans ces conditions, les m thermocouples sont reliés électriquement en série et sont formés par (2*m) barreaux formant un nombre de jonctions P/N égales à (2*m - 1).

Les barreaux des thermocouples du dispositif 10 sont, de préférence, formés en technologie CMOS ou BiCMOS. De ce fait, le dopage des barreaux peut être réalisé par des implantations ioniques usuelles de type N et P utilisées pour la réalisation des transistors MOS standards. Dans ces conditions, il est possible que les résistivités électriques des barreaux dopés N et P soient différentes. Dans certaines conditions de réalisation, un facteur 2 à 3 entre les résistivités des deux barreaux dopés N et P peut exister. Afin de compenser cette différence de résistivité lorsque les niveaux de dopage sont fixés (par exemple par les autres composants du circuit) un ajustement adéquat des dimensions géométriques des barreaux formant les thermocouples du dispositif 10 peut être envisagé : pour une surface donnée du capteur différentiel de température, la force électromotrice Seebeck entre $S_1$ et $S_2$ sera la plus grande possible et la résistance série introduite par le matériau des barreaux 13 et 14 sera la plus faible possible.

Comme illustré à la figure 4, les thermocouples du dispositif 10 sont thermiquement en parallèle, c'est-à-dire disposés dans un même gradient thermique imposé par les côtés chaud 12 et froid 11. Ces thermocouples sont formés par des barreaux disposés en « créneau », s'étendant continûment suivant la longueur des barreaux du côté chaud 12 au côté froid 11. Ainsi, selon ce mode de réalisation, les barreaux du dispositif 10 sont parallèles et ils ont la même longueur $L$ qui est de l'ordre de la distance qui sépare les côtés chaud 12 et froid 11. L'épaisseur, dimension suivant l'axe « z », des barreaux peut également être choisie selon des considérations technologiques. En effet, en technologie CMOS ou BiCMOS les barreaux sont, de préférence, déposés simultanément et ils ont une même épaisseur.

Dans un mode de réalisation qui peut être combiné aux précédents, au moins un des barreaux formant les sorties du dispositif thermoélectrique 10 est plus long que les autres barreaux du dispositif 10.

Comme illustré à la figure **4,** les barreaux formant les thermocouples 15-1 et 15-2 ont avantageusement des largeurs $l_N$ et $l_P$ différentes suivant le type de conductivité des barreaux. Ces largeurs $l_N$ et $l_P$ sont choisies de manière à contrôler les résistances électriques des barreaux formant les thermocouples 15-1 et 15-2.

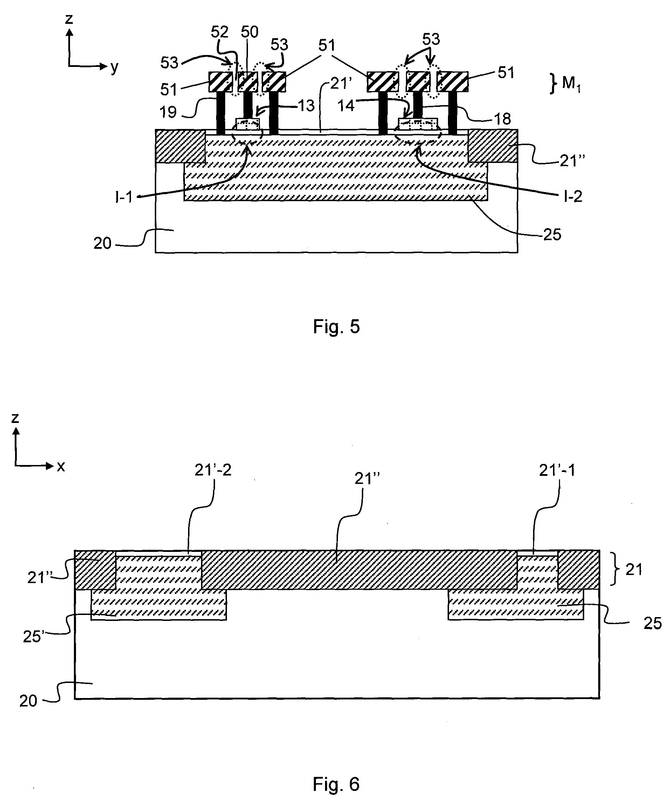

Dans un mode particulier de réalisation illustré à la figure 5, une augmentation de la valeur de la capacité

associée aux sorties $S_1$ et $S_2$ peut être réalisée grâce à des contacts électriques reliant un niveau de métallisation avec le substrat 20 et les bornes de sortie $S_1$ et $S_2$. Ce mode de réalisation peut également être combiné aux modes précédents.

La figure 5 illustre une vue en coupe selon l'axe yoy' de la figure 4. Au moins des première 50 et deuxième 51 lignes métalliques sont respectivement connectées au barreau d'une des sorties du dispositif 10 et à la zone 25 du substrat 20, c'est-à-dire la deuxième électrode du condensateur de cette sortie. La première ligne métallique 50 est connectée à la sortie via un contact 18, et la ligne 51 est connectée à la zone 25 via un contact 19. Les lignes métalliques 50 et 51 sont adjacentes et séparées l'une de l'autre par une couche 52 en matériau électriquement isolant, par exemple un oxyde de silicium, un nitrure de silicium, du vide ou un gaz. De ce fait, un condensateur 53 de type Métal / Isolant / Métal (MIM) peut être formé par les deux lignes métalliques adjacentes 50 et 51. Le condensateur 53 est disposé dans un plan différent du plan des sorties du dispositif 10 parallèle à la surface du substrat et du premier barreau. La valeur de la capacité du condensateur 53 est fonction de la surface en regard entre les lignes 50 et 51, de la valeur d'entrefer entre ces deux lignes et du matériau les séparant. Les contacts 18 et 19 peuvent également intervenir dans la valeur de la capacité selon les architectures utilisées. Pour des raisons de clarté, les contacts électriques 18, 19 et les lignes 50, 51 n'ont pas été illustrés aux figures 1 et 4.

Dans un mode préférentiel de réalisation, les sorties $S_1$ et $S_2$ comportent les contacts métalliques 18 disposés au-dessus des barreaux 13 et 14. Les contacts métalliques 19 sont disposés au niveau du côté froid 11. Plusieurs contacts 19 sont formés pour un contact 18 et ils sont formés de manière à ce qu'au moins deux contacts 19 soient séparés par le barreau 13 et au moins deux autres contacts 19 soient séparés par le barreau 14. Les contacts 18 relient électriquement les sorties $S_1$ et $S_2$ avec les lignes métalliques 50 qui les chevauchent. Les contacts 19 relient électriquement les zones du substrat 20 avec les lignes métalliques 51 qui les chevauchent. Les lignes 50 et 51 appartiennent au même niveau de métallisation pour une même sortie, ici un niveau $M_1$. D'autres niveaux de métallisation peuvent également être disposés au-dessus du niveau $M_1$ pour accroître la valeur des condensateurs ajoutés en parallèle aux condensateurs I-1 et I-2.

Les contacts 19 permettent également une connexion thermique entre le substrat 20 via la zone 25 et les deuxièmes lignes métalliques 51. Augmenter le nombre de contacts 19 permet d'augmenter le transfert thermique du substrat à travers le film 21' et donc l'effet du gradient thermique entre la zone froide 11 et la zone chaude 12. De manière avantageuse, les contacts 19 sont formés de part et d'autre du contact 18 pour avoir une répartition homogène de la température du substrat. Les contacts électriques 18 et 19 peuvent être formés par des plots à base de matériaux électriquement conducteurs. Ces contacts peuvent être, par exemple, en Cu ou en Ti/Au. Les lignes métalliques 50 et 51 peuvent être, par exemple en Cu ou tout autre matériau métallique usuellement utilisé dans la technologie CMOS/BiCMOS pour la réalisation des interconnexions.

Comme illustré à la figure 5, les condensateurs 53 comportent des premières électrodes formées par les lignes métalliques 50 qui sont reliées aux premier 13 et deuxième 14 barreaux par les contacts 18. Par ailleurs, les deuxièmes électrodes des condensateurs 53 sont formées par les lignes métalliques 51 qui sont reliées aux deuxièmes électrodes des condensateurs I-1 et I-2 par les contacts 19. De ce fait, chacun des condensateurs I-1 et I-2 est disposé électriquement en parallèle avec au moins un condensateur, par exemple deux condensateurs 53. La vue en coupe de la figure 5 peut représenter deux condensateurs 53 associés au barreau 14 et deux condensateurs 53 associés au barreau 13. Chaque couple de condensateur ayant la ligne 50 comme électrode commune. La vue en coupe de la figure 5 peut également représenter un seul condensateur 53 de forme cylindrique ou semi-cylindrique avec l'électrode 50 qui est entourée ou partiellement entourée par une même ligne métallique 51. Dans cette architecture particulière, une seule ligne 19 peut être utilisée.

Ainsi, les bornes de sortie $S_1$ et $S_2$ comportent chacune au moins deux condensateurs en parallèles. Ces condensateurs sont équivalents à un seul condensateur I-eq ayant une valeur de capacité électrique de l'ordre de la somme des valeurs de capacité des différents condensateurs montés en parallèle. Par conséquent, les condensateurs 53 permettent avantageusement d'augmenter la valeur de la capacité électrique de découplage aux bornes de sortie $S_1$ et $S_2$.

Selon ce mode de réalisation, les bornes de sortie $S_1$ et $S_2$ sont avantageusement munies de condensateurs I-eq réalisés en technologie CMOS/BiCMOS et ayant des valeurs de capacité par unité de surface supérieures à $C_1$. Ces condensateurs permettent une meilleure protection du dispositif thermoélectrique 10 contre d'éventuelles perturbations électriques.

La disposition des lignes métalliques 50, 51 et des contacts 18, 19 au voisinage des bornes de sorties $S_1$ et $S_2$ permet également une harmonisation de la température au niveau du côté froid 11 à une température proche de celle du substrat 20. En effet, ces lignes et ces contacts sont formés, de préférence, à base de matériaux métalliques qui, grâce à leur importante conductivité thermique, permettent une dissipation efficace du flux thermique.

Les figures 6 à 8 illustrent des étapes successives d'un procédé de réalisation d'un dispositif thermoélectrique 10 et d'un dispositif actif en technologie CMOS ou BiCMOS.

La figure 6 illustre un substrat 20 de départ réalisé suivant des étapes usuelles de la technologie CMOS/BiCMOS. Le substrat 20 peut être dopé de manière à avoir un premier type de conductivité. On peut distinguer également, une couche 21 électriquement isolante qui recouvre partiellement une face du substrat 20. La couche électriquement isolante 21 comporte des première 21'-1, deuxième 21" et troisième 21'-2 portions.

Les première 21'-1 et troisième 21'-2 portions présentent une même valeur de capacité par unité de surface et la deuxième portion 21 " présente une deuxième valeur de capacité par unité de surface inférieure à la première valeur. Les première 21'-1 et troisième 21'-2 portions présentent également une même première valeur de conductance thermique et la deuxième portion 21 " présente une deuxième valeur de conductance thermique inférieure à la première valeur. Par conductance thermique, on entend l'inverse de la résistance thermique.

De préférence, les première 21'-1 et troisième 21'-2 portions sont séparées par la deuxième portion 21 ". Les trois portions de la couche électriquement isolante peuvent être formées à partir de matériaux différents, ou bien à partir du même matériau. Dans un mode de mise en oeuvre particulier, les première 21'-1 et troisième 21'-2 sont formées par le même film électriquement isolant, alors que la deuxième portion 21" est formée à partir d'un autre film électriquement isolant.

Dans un mode de mise en oeuvre préférentiel, les portions de la couche électriquement isolante 21 sont à base d'oxyde de silicium ($SiO_2$). Les première 21'-1 et troisième 21'-2 portions peuvent être à base d'un oxyde de silicium utilisé généralement comme diélectrique de grille. Elles peuvent être formées simultanément et peuvent avoir une même épaisseur $e'$. La deuxième portion 21" peut être formée de la même manière qu'une tranchée d'isolation dite STI (STI du terme usuel anglais « Shallow Trench Isolation) qui s'enfonce dans le substrat. La deuxième portion 21" peut avoir une épaisseur $e''$ supérieure à l'épaisseur $e'$. De cette manière, les valeurs de capacité par unité de surface et de conductance thermique de la portion 21 " sont inférieures à celles des portions 21'-1 et 21'-2. À titre d'exemple, la deuxième portion 21" est formée, au moins partiellement, avant les première 21'-1 et troisième 21'-2 portions.

Le substrat 20 comporte éventuellement des première 25 et deuxième 25' zones dopées de manière à avoir le second type de conductivité. De ce fait, ces zones 25 et 25' forment avec des zones adjacentes du substrat 20 des jonctions P/N. De préférence, les zones 25 et 25' sont dopées simultanément à l'aide d'une implantation ionique usuelle utilisée pour la réalisation des transistors. Les zones 25 et 25' sont disposées dans le substrat 20 de manière à ce qu'elles fassent face respectivement aux première 21'-1 et troisième 21'-2 portions de la couche électriquement isolante 21. Dans un mode de mise en oeuvre particulier, les zones 25 et 25' sont formées avant les première 21'-1 et troisième 21'-2 portions.

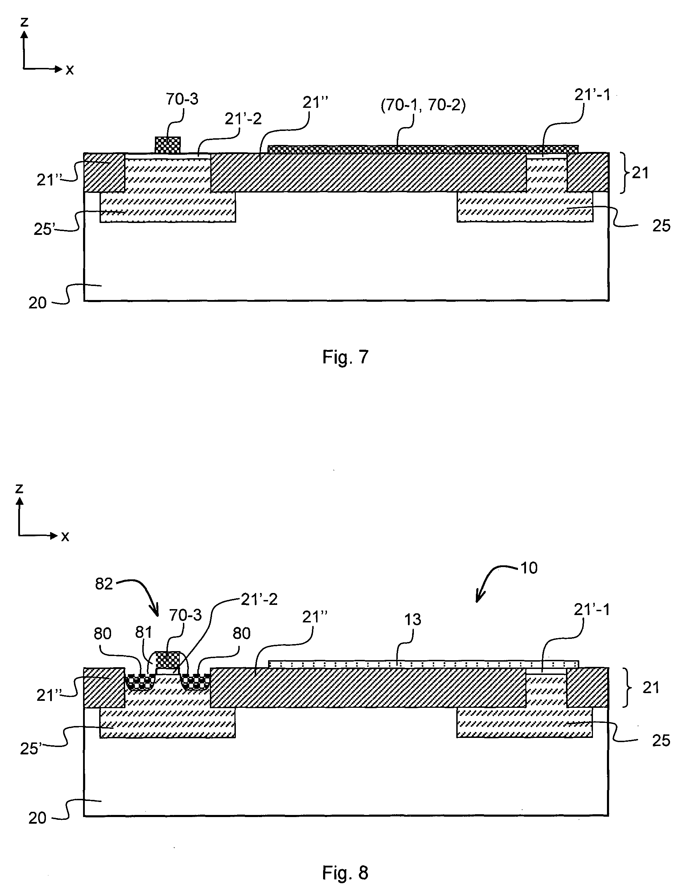

Comme illustré à la figure 7, des premier 70-1 et deuxième 70-2 barreaux en matériau électriquement conducteur sont formées au-dessus de la couche électriquement isolante 21. Les barreaux 70-1 et 70-2 s'étendent au-dessus des premières 21'-1 et deuxième 21" portions de la couche électriquement isolante 21. Les matériaux des barreaux 70-1 et 70-2 sont choisis de manière à ce que ces barreaux puissent participer à la formation d'au moins un thermocouple. Un troisième barreau 70-3 en matériau électriquement conducteur est également formé au-dessus de la troisième portion 21'-2 de la couche électriquement isolante 21.

Dans un mode particulier de mise en oeuvre qui peut être combiné aux précédents, les barreaux 70-1, 70-2 et 70-3 sont formés simultanément et à base du même matériau. Les trois barreaux sont réalisés, par exemple, en silicium polycristallin. Dans cette configuration, les barreaux 70-1 et 70-2 peuvent servir d'éléments de base pour former un dispositif thermoélectrique du type du dispositif 10. L'empilement formé par le barreau 70-3 qui est disposé au-dessus de la troisième portion 21'-2 de la couche électriquement isolante peut avantageusement être utilisé pour réaliser un empilement de grille pour la réalisation d'un transistor à effet de champ en technologie CMOS.

En effet, comme illustré à la figure 8, les barreaux 70-1 et 70-2 peuvent être dopés, par la suite, de manière à avoir des types de conductivité différents. Pour ce faire, des étapes d'implantation ionique usuelles peuvent être mises en oeuvre pour former les premier 13 et deuxième 14 barreaux dopés N et P. Ces étapes d'implantation peuvent également être utilisées pour réaliser des zones source et drain 80 après une étape de délimitation de l'électrode de grille. Par exemple, une étape de photolithographie usuelle peut être utilisée pour éliminer sélectivement la troisième portion 21'-2. De ce fait, les barreaux du thermocouple et de l'électrode de grille sont délimités simultanément avec la même étape de photolithographie et la même étape de gravure. Le dopage des barreaux du thermocouple peut être réalisé lors du dopage de l'électrode de grille.

Ainsi, il a été possible de réaliser trois éléments essentiels d'un transistor à effet de champ 82 usuel : les zones source et drain 80 et l'empilement de grille 70-3/21'-2. Ce procédé permet avantageusement de réaliser une co-intégration d'un dispositif thermoélectrique de même type que le dispositif 10 et d'un dispositif actif usuel de la technologie CMOS/BiCMOS tel qu'un transistor à effet de champ. Ce transistor ainsi formé peut être encapsulé par des couches 81 en matériau électriquement isolant, par exemple en oxyde ou en nitrure de silicium. Ces couches 81 sont communément appelées des espaceurs et servent à isoler électriquement la grille des régions source et drain 80.

**Revendications**

1. Dispositif thermoélectrique (10) comportant :

- un substrat en matériau semi-conducteur (20) ;
- une couche électriquement isolante (21) recouvrant une face du substrat (20) ;
- un thermocouple (15) séparé du substrat par la couche électriquement isolante (21) ;
- des première (S$_1$) et seconde (S$_2$) bornes de sortie reliées au thermocouple (15) ;

dispositif **caractérisé en ce que** :

- la couche électriquement isolante (21) comporte une première portion (21') présentant une première valeur de capacité par unité de surface et une deuxième portion (21") présentant une deuxième valeur de capacité par unité de surface inférieure à la première valeur ;
- la première borne de sortie (S$_1$) comporte un premier condensateur (I-1) ayant une première électrode formée par un premier barreau (13) en matériau électriquement conducteur et une deuxième électrode formée par une partie du substrat (20) faisant face audit premier barreau (13) et séparée de la première électrode par la première portion (21') de la couche électriquement isolante, le premier barreau (13) chevauchant la deuxième portion (21") de la couche électriquement isolante pour relier le thermocouple (15).

2. Dispositif thermoélectrique selon la revendication 1 dans lequel la seconde borne de sortie (S$_2$) comporte un deuxième condensateur (I-2) ayant une première électrode formée par un deuxième barreau (14) en matériau électriquement conducteur et une deuxième électrode formée par une partie du substrat (20) faisant face audit deuxième barreau (14) et séparée de la première électrode par la première portion (21') de la couche électriquement isolante, le deuxième barreau (14) chevauchant la deuxième portion (21") de la couche électriquement isolante pour relier le thermocouple (15).

3. Dispositif thermoélectrique selon l'une des revendications 1 et 2 dans lequel une zone (25) du substrat faisant face à la première portion (21') de la couche électriquement isolante est dopée de manière à former une jonction P/N avec une zone adjacente du substrat (20).

4. Dispositif thermoélectrique selon la revendication 1 dans lequel, le premier barreau (13) et la deuxième électrode du condensateur (I-1) de la première borne de sortie (S$_1$) sont respectivement connectés électriquement à une première ligne métallique (50) et à une deuxième ligne métallique (51) de manière à ce que lesdites première (50) et deuxième (51) lignes métalliques soient séparées l'une de l'autre par une couche (52) en matériau électriquement isolant et à ce qu'elles soient disposées dans un plan parallèle et différent du plan du premier barreau (13).

5. Dispositif thermoélectrique selon l'une quelconque des revendications 1 à 4 dans lequel les premier (13) et deuxième (14) barreaux sont en matériaux semi-conducteurs dopés et participent à la formation d'au moins un thermocouple (15).

6. Dispositif thermoélectrique selon la revendication 5 dans lequel le premier barreau (13) reliant une jonction thermoélectrique à la première sortie S$_1$ a un premier type de conductivité et le deuxième barreau (14) a une première portion (14') en premier type de conductivité et une seconde portion (14") en second type de conductivité de manière à ce que la première portion du deuxième barreau (14') et le premier barreau (13) aient le même type de conductivité au-dessus de la première portion (21') de la couche électriquement isolante (21), les première et seconde (14', 14") portions étant alignées.

7. Dispositif thermoélectrique selon la revendication 6 dans lequel une couche à base d'un matériau électriquement conducteur (27) forme un court-circuit entre les première (14') et seconde (14") portions du deuxième barreau (14).

8. Dispositif thermoélectrique selon l'une quelconque des revendications 1 à 7 dans lequel la première portion (21') de la couche électriquement isolante présente une première valeur (Rth1) de résistance thermique et la deuxième portion (21 ") de la couche électriquement isolante présente une deuxième valeur de résistance thermique (Rth2) supérieure à la première valeur.

9. Dispositif thermoélectrique (10) selon l'une quelconque des revendications 1 à 8 **caractérisé en ce qu'**il comporte une pluralité de thermocouples (15-1) connectés en série, chaque thermocouple comportant deux barreaux reliés par une liaison thermoélectrique, le premier barreau (13) étant le barreau le plus long des barreaux du dispositif (10).

10. Dispositif thermoélectrique (10) selon l'une quelconque des revendications 1 à 9 dans lequel l'épaisseur de la première portion (21') de la couche électriquement isolante (21) est comprise entre 3 et 200 Å.

11. Procédé de fabrication d'un dispositif thermoélectrique comportant les étapes suivantes :

- Prévoir un substrat (20) en un matériau semi-conducteur ayant un premier type de conductivité et comportant une couche électriquement isolante (21) recouvrant une face du substrat (20), ladite couche électriquement isolante (21)

comporte des première (21-1') et troisième (21-2') portions présentant des premières valeurs de capacité par unité de surface et de conductance thermique ; et une deuxième portion (21 ") présentant des deuxièmes valeurs de capacité par unité de surface et de conductance thermique inférieures respectivement aux premières valeurs ;

- Former simultanément des premier (70-1) et deuxième (70-2) barreaux en matériau électriquement conducteur s'étendant au-dessus des première (21'-1) et deuxième (21") portions de la couche électriquement isolante (21) ; et un troisième (70-3) barreau en matériau électriquement conducteur au-dessus de la troisième portion (21'-2) de la couche électriquement isolante ;

- Doper les premier, deuxième et troisième barreaux (70-1, 70-2, 70-3) de manière à former un thermocouple au moyen des premier et deuxième barreaux (70-1, 70-2) et un transistor MOS au moyen du troisième barreau (70-3).

12. Procédé selon la revendication 11 dans lequel avant la formation, des premier, deuxième et troisième (70-1, 70-2, 70-3) barreaux, des première (25) et deuxième (25') zones sont formés dans le substrat (20) ; les première (25) et deuxième (25') zones ayant le second type de conductivité et faisant face respectivement aux première (21'-1) et troisième (21'-2) portions de la couche électriquement isolante (21).

**Patentansprüche**

1. Thermoelektrische Vorrichtung (10), umfassend:

    - ein Substrat aus Halbleitermaterial (20);
    - eine elektrisch isolierende Schicht (21), die eine Seite des Substrats (20) bedeckt;
    - ein Thermoelement (15), das von dem Substrat durch die elektrisch isolierende Schicht (21) getrennt ist;
    - einen ersten ($S_1$) und einen zweiten ($S_2$) Ausgangsanschluss, die mit dem Thermoelement (15) verbunden sind;

    Vorrichtung, **dadurch gekennzeichnet, dass**:

    - die elektrisch isolierende Schicht (21) einen ersten Abschnitt (21'), der einen ersten Kapazitätswert pro Flächeneinheit aufweist, und einen zweiten Abschnitt (21"), der einen zweiten Kapazitätswert pro Flächeneinheit, welcher kleiner als der erste Wert ist, aufweist, umfasst;
    - der erste Ausgangsanschluss ($S_1$) einen ersten Kondensator (I-1) umfasst, der eine erste Elektrode, die durch einen ersten Stab (13) aus elektrisch leitendem Material gebildet ist, und eine zweite Elektrode aufweist, die durch einen Teil des Substrats (20), welcher dem ersten Stab (13) gegenüberliegt und von der ersten Elektrode durch den ersten Abschnitt (21') der elektrisch isolierenden Schicht getrennt ist, gebildet ist, wobei der erste Stab (13) den zweiten Abschnitt (21") der elektrisch isolierenden Schicht überlappt, um das Thermoelement (15) zu verbinden.

2. Thermoelektrische Vorrichtung nach Anspruch 1, wobei der zweite Ausgangsanschluss ($S_2$) einen zweiten Kondensator (1-2) umfasst, der eine erste Elektrode, die durch einen zweiten Stab (14) aus elektrisch leitendem Material gebildet ist, und eine zweite Elektrode aufweist, die durch einen Teil des Substrats (20), welcher dem zweiten Stab (14) gegenüberliegt und von der ersten Elektrode durch den ersten Abschnitt (21') der elektrisch isolierenden Schicht getrennt ist, gebildet ist, wobei der zweite Stab (14) den zweiten Abschnitt (21") der elektrisch isolierenden Schicht überlappt, um das Thermoelement (15) zu verbinden.

3. Thermoelektrische Vorrichtung nach einem der Ansprüche 1 und 2, wobei ein Bereich (25) des Substrats, der dem ersten Abschnitt (21') der elektrisch isolierenden Schicht gegenüberliegt, derart dotiert ist, dass er einen PN-Übergang mit einem benachbarten Bereich des Substrats (20) bildet.

4. Thermoelektrische Vorrichtung nach Anspruch 1, wobei der erste Stab (13) und die zweite Elektrode des Kondensators (I-1) des ersten Ausgangsanschlusses ($S_1$) mit einer ersten Metallleitung (50) bzw. mit einer zweiten Metallleitung (51) elektrisch verbunden sind, so dass die erste (50) und die zweite (51) Metallleitung durch eine Schicht (52) aus elektrisch isolierendem Material voneinander getrennt sind und dass sie in einer parallelen und von der Ebene des ersten Stabs (13) verschiedenen Ebene angeordnet sind.

5. Thermoelektrische Vorrichtung nach einem der Ansprüche 1 bis 4, wobei der erste (13) und der zweite (14) Stab aus dotierten Halbleitermaterialien bestehen und an der Bildung wenigstens eines Thermoelements (15) beteiligt sind.

6. Thermoelektrische Vorrichtung nach Anspruch 5, wobei der erste Stab (13), der einen thermoelektrischen Übergang mit dem ersten Ausgang ($S_1$) verbindet, einen ersten Leitfähigkeitstyp aufweist und der zweite Stab (14) einen ersten Abschnitt (14') mit erstem Leitfähigkeitstyp und einen zweiten Abschnitt (14") mit zweitem Leitfähigkeitstyp aufweist, so dass der erste Abschnitt des zweiten Stabs (14') und der erste Stab (13) den gleichen Leitfähigkeitstyp oberhalb des ersten Abschnitts (21') der elektrisch isolierenden Schicht (21) aufweisen, wobei der erste und der zweite (14', 14") Abschnitt miteinander fluchten.

7. Thermoelektrische Vorrichtung nach Anspruch 6, wobei eine Schicht auf der Basis eines elektrisch leitenden Materials (27) einen Kurzschluss zwischen dem ersten (14') und dem zweiten (14") Abschnitt des zweiten Stabs (14) bildet.

8. Thermoelektrische Vorrichtung nach einem der Ansprüche 1 bis 7, wobei der erste Abschnitt (21') der elektrisch isolierenden Schicht einen ersten Wärmewiderstandswert (Rth1) aufweist und der zweite Abschnitt (21") der elektrisch isolierenden Schicht einen zweiten Wärmewiderstandswert (Rth2), welcher größer als der erste Wert ist, aufweist.

9. Thermoelektrische Vorrichtung (10) nach einem der Ansprüche 1 bis 8, **dadurch gekennzeichnet, dass** sie eine Vielzahl von in Reihe geschalteten Thermoelementen (15-1) umfasst, wobei ein jedes Thermoelement zwei durch eine thermoelektrische Verbindung verbundene Stäbe umfasst, wobei der erste Stab (13) der längste Stab der Stäbe der Vorrichtung (10) ist.

10. Thermoelektrische Vorrichtung (10) nach einem der Ansprüche 1 bis 9, wobei die Dicke des ersten Abschnitts (21') der elektrisch isolierenden Schicht (21) zwischen 3 und 200 Å beträgt.

11. Verfahren zur Herstellung einer thermoelektrischen Vorrichtung, das die folgenden Schritte umfasst:

- Vorsehen eines Substrats (20) aus einem Halbleitermaterial, das einen ersten Leitfähigkeitstyp aufweist und eine elektrisch isolierende Schicht (21) aufweist, welche eine Seite des Substrats (20) bedeckt, wobei die elektrisch isolierende Schicht (21) einen ersten (21-1') und einen dritten (21-2') Abschnitt mit ersten Kapazitätswerten pro Flächeneinheit und Wärmeleitfähigkeit sowie einen zweiten Abschnitt (21") mit zweiten Kapazitätswerten pro Flächeneinheit und Wärmeleitfähigkeit, die jeweils geringer als die ersten Werte sind, umfasst;
- gleichzeitiges Ausbilden eines ersten (70-1) und eines zweiten (70-2) Stabs aus elektrisch leitendem Material, die sich oberhalb des ersten (21'-1) und des zweiten (21") Abschnitts der elektrisch isolierenden Schicht (21) erstrecken, sowie eines dritten (70-3) Stabs aus elektrisch leitendem Material oberhalb des dritten Abschnitts (21'-2) der elektrisch isolierenden Schicht;
- Dotieren des ersten, des zweiten und des dritten Stabs (70-1, 70-2, 70-3), um ein Thermoelement mittels des ersten und des zweiten Stabs (70-1, 70-2) und einen MOS-Transistor mittels des dritten Stabs (70-3) zu bilden.

12. Verfahren nach Anspruch 11, wobei vor dem Ausbilden des ersten, des zweiten und des dritten (70-1, 70-2, 70-3) Stabs ein erster (25) und ein zweiter (25') Bereich in dem Substrat (20) ausgebildet werden; wobei der erste (25) und der zweite (25') Bereich den zweiten Leitfähigkeitstyp aufweisen und dem ersten (21'-1) bzw. dem dritten (21'-2) Abschnitt der elektrisch isolierenden Schicht (21) gegenüberliegen.

**Claims**

1. A thermoelectric device (10) comprising:

- a substrate made from semiconductor material (20);
- an electrically insulating layer (21) covering one surface of the substrate (20);
- a thermocouple (15) separated from the substrate by the electrically insulating layer (21);
- first ($S_1$) and second ($S_2$) output terminals connected to the thermocouple (15);

a device **characterized in that**:

- the electrically insulating layer (21) comprises a first portion (21') presenting a first value of capacitance per unit area and a second portion (21") presenting a second value of capacitance per unit area that is lower than the first value;
- the first output terminal ($S_1$) comprises a first capacitor (I-1) having a first electrode formed by a first leg (13) made from electrically conducting material and a second electrode formed by a part of the substrate (20) facing said first leg (13) and separated from the first electrode by the first portion (21') of the electrically insulating layer, the first leg (13) overlapping the second portion (21") of the electrically insulating layer to connect the thermocouple (15).

2. The thermoelectric device according to claim 1 wherein the second output terminal ($S_2$) comprises a second capacitor (I-2) having a first electrode formed by a second leg (14) made from electrically conducting material and a second electrode formed by a part of the substrate (20) facing said second leg (14) and separated from the first electrode by the first portion (21') of the electrically insulating layer, the second leg (14) overlapping the second portion (21") of the electrically insulating layer to connect the thermocouple (15).

3. The thermoelectric device according to one of claims 1 and 2 wherein an area (25) of the substrate facing the first portion (21') of the electrically insulating layer is doped so as to form a P/N junction with an adjacent area of the substrate (20).

4. The thermoelectric device according to claim 1 wherein the first leg (13) and the second electrode of the capacitor (I-1) of the first output terminal ($S_1$) are respectively electrically connected to a first metal line (50) and to a second metal line (51) in such a way that said first (50) and second (51) metal lines are separated from one another by a layer (52) of electrically insulating material and in that they are arranged in a plane that is parallel to and different from the plane of the first leg (13).

5. The thermoelectric device according to any one of claims 1 to 4 wherein the first (13) and second (14) legs are made from doped semiconductor materials and participate in formation of at least one thermocouple (15).

6. The thermoelectric device according to claim 5 wherein the first leg (13) connecting a thermoelectric junction to the first output $S_1$ has a first type of conductivity and the second leg (14) has a first portion (14') having a first type of conductivity and a second portion (14") having a second type of conductivity so that the first portion of the second leg (14') and the first leg (13) have the same type of conductivity above the first portion (21') of the electrically insulating layer (21), the first and second portions (14', 14") being aligned.

7. The thermoelectric device according to claim 6 wherein a layer having a base formed by an electrically conducting material (27) forms a short-circuit between the first (14') and second (14") portions of the second leg (14).

8. The thermoelectric device according to any one of claims 1 to 7 wherein the first portion (21') of the electrically insulating layer presents a first thermal resistance value (Rth1) and the second portion (21") of the electrically insulating layer presents a second thermal resistance value (Rth2) that is higher than the first value.

9. The thermoelectric device (10) according to any one of claims 1 to 8 **characterized in that** it comprises a plurality of thermocouples (15-1) connected in series, each thermocouple comprising two legs connected by a thermoelectric connection, the first leg (13) being the longer leg of the legs of the device (10).

10. the thermoelectric device (10) according to any one of claims 1 to 9 wherein the thickness of the first portion (21') of the electrically insulating layer (21) is comprised between 3 and 200 Å.

11. A method for fabricating a thermoelectric device comprising the following steps:

- providing a substrate (20) made from a semiconductor material having a first type of conductivity and comprising an electrically insulating layer (21) covering one surface of the substrate (20), said electrically insulating layer (21) comprising first (21-1') and third (21-2') portions presenting first capacitance per unit area and thermal conductance values; and a second portion (21") presenting second capacitance per unit area and thermal conductance values that are respectively lower than the first values;
- simultaneously forming first (70-1) and second (70-2) legs made from electrically conducting material extending above the first (21'-1) and second (21") portions of the electrically insulating layer (21); and a third leg (70-3) made from electrically conducting material above the third portion (21'-2) of the electrically insulating layer;
- doping the first, second and third legs (70-1, 70-2, 70-3) so as to form a thermocouple by means of the first and second legs (70-1, 70-2) and a MOS transistor by means of the third leg (70-3).

12. the method according to claim 11 wherein, before formation of the first, second and third (70-1, 70-2, 70-3) legs, first (25) and second (25') areas are formed in the substrate (20); the first (25) and second (25') areas having the second type of conductivity and respectively facing the first (21'-1) and third (21'-2) portions of the electrically insulating layer (21).

Fig. 1

Fig. 2

Fig. 3

Fig. 4

Fig. 5

Fig. 6

Fig. 7

Fig. 8

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2001012586 A1

**Littérature non-brevet citée dans la description**

- **E. ALDRETE-VIDRIO et al.** Differential temperature sensors in $0.35\mu$m CMOS technology. *conférence THERMINIC,* 2005